# EUROPEAN PATENT APPLICATION

(11) **EP 4 502 228 A1**
(43) Date of publication of application: **05.02.2025**
(21) Application number: 23781217.7
(22) Date of filing: 17.03.2023
(51) Int. Cl.: C23C 16/04, C23C 16/455, C23C 16/34, C23C 16/40, H01L 21/02, H01L 21/285

(54) **THIN FILM MODIFICATION COMPOSITION, METHOD FOR FORMING THIN FILM USING SAME, AND SEMICONDUCTOR SUBSTRATE AND SEMICONDUCTOR ELEMENT, MANUFACTURED THEREFROM**

(30) Priority: 28.03.2022 KR 20220037733; 25.10.2022 KR 20220138089
(71) Applicant: Soulbrain Co., Ltd., Seongnam-si, Gyeonggi-do 13486 (KR)
(72) Inventor: LEE, Seung Hyun, Seongnam-si, Gyeonggi-do 13486 (KR); JUNG, Jae Sun, Seongnam-si, Gyeonggi-do 13486 (KR); KIM, Deok Hyun, Seongnam-si, Gyeonggi-do 13486 (KR)
(74) Representative: Dehns
(86) International application number: PCT/KR2023/003583
(87) International publication number: WO 2023/191361

(57) **Abstract**

The present invention relates to a thin film modification composition, a method of forming a thin film using the thin film modification composition, a semiconductor substrate including the thin film, and a semiconductor device including the semiconductor substrate. According to the present invention, by using a shielding material and a diffusion-improving agent in combination, the reaction speed may be improved and the thin film growth rate may be appropriately reduced. Thus, even when forming a thin film on a substrate with a complex structure under high-temperature conditions, step coverage and the thickness uniformity of a thin film may be greatly improved, impurities may be reduced, and film quality may be improved.

## Description

### [Technical Field]

The present invention relates to a thin film modification composition, a method of forming a thin film using the thin film modification composition, and a semiconductor substrate including the thin film. More particularly, according to the present invention, by providing a thin film modification composition including a shielding material and a diffusion-improving agent, by effectively shielding a substrate even under high-temperature conditions, the reaction speed may be improved and the thin film growth rate may be appropriately reduced. In addition, even when forming a thin film on a substrate with a complex structure, step coverage and the thickness uniformity of a thin film may be improved, impurities may be greatly reduced, and the film quality may be improved.

### [Background Art]

As the integration of memory and non-memory semiconductor devices increases, the microstructure of a substrate is becoming increasingly complex.

For example, the ratio of the width to depth of the microstructure (hereinafter referred to as the 'aspect ratio') is increasing to 20:1 or more, and even to 100:1 or more. As the aspect ratio increases, it becomes difficult to form a deposition layer with a uniform thickness along the plane of the complex microstructure.

Accordingly, step coverage, which defines the thickness ratio of deposition layers formed at the top and bottom in the depth direction of the microstructure, remains at the level of 90 %. Accordingly, the expression of the electrical characteristics of a device becomes increasingly difficult. Since a step coverage of 100 % means that deposition layers formed on the upper and lower parts of the microstructure have the same thickness, it is necessary to develop a technology that can achieve step coverage close to 100 %.

That is, to provide excellent and uniform physical properties to a thin film deposited on a substrate, it is essential that the thin film has high step coverage. Accordingly, the atomic layer deposition (ALD) process, which uses surface reactions, is used rather than the chemical vapor deposition (CVD) process, which mainly uses gaseous reactions. However, there are still problems in implementing 100 % step coverage.

When increasing deposition temperature to achieve 100 % step coverage, it is difficult to achieve step coverage. First, in a deposition process using a precursor and a reactant, an increase in the deposition temperature leads to a steep increase in the thin film growth rate (GPC). In addition, even when the ALD process is performed at 300 °C to alleviate the increase in GPC due to the increase in deposition temperature, the deposition temperature increases during the process. Accordingly, the problem still remains.

In addition, high-temperature processes are required to realize metal oxide films with excellent film quality in semiconductor devices. A study has been reported in which the concentration of carbon and hydrogen remaining in a thin film was reduced by increasing the atomic layer deposition temperature to 400 °C (See the paper J. Vac. Sci. Technol. A, 35(2017) 01B130).

However, as the deposition temperature increases, it becomes difficult to ensure step coverage. First, in a deposition process using a precursor and a reactant, an increase in deposition temperature may lead to a sharp increase in thin film growth rate (GPC). In addition, even when a known shielding agent is applied to reduce the increase in GPC with increasing deposition temperature, it is confirmed that GPC increases by about 10 % at 300 °C. That is, when deposition is performed at temperatures above 360 °C, it is difficult to expect the GPC reduction effect provided by the conventionally known shielding agent.

Therefore, there is a need to develop a thin film formation method that allows the formation of a thin film with a complex structure effectively even at high temperatures, reduces the residual amount of impurities, and improves step coverage and the thickness uniformity of a thin film and a semiconductor substrate including the thin film.

### [Disclosure]

### [Technical Problem]

Therefore, the present invention has been made in view of the above problems, and it is one object of the present invention to provide a thin film modification composition, a method of forming a thin film using the thin film modification composition, and a semiconductor substrate including the thin film. According to the present invention, by using a shielding material and a diffusion-improving agent in combination, a substrate may be effectively shielded, reaction speed may be improved, and thin film growth rate may be appropriately reduced. Thus, even when forming a thin film on a substrate with a complex structure, step coverage and the thickness uniformity of a thin film may be greatly improved, impurities may be reduced, and film quality may be improved.

It is another object of the present invention to improve the density, electrical properties, and dielectric properties of a thin film by improving the crystallinity and oxidation fraction of the thin film.

The above and other objects can be accomplished by the present invention described below.

### [Technical Solution]

In accordance with one aspect of the present invention, provided is a thin film modification composition including 50 to 99 parts by weight of a shielding material having one or more unshared electron pairs selected from oxygen (O), sulfur (S), and phosphorus (P) and 1 to 50 parts by weight of a diffusion-improving agent,
wherein the diffusion-improving agent has a boiling point of 5 to 200 °C.

The shielding material may have two or more oxygen (O), phosphorus (P), or sulfur (S) elements and may include a linear or cyclic saturated or unsaturated hydrocarbon having 3 to 15 carbon atoms.

The shielding material may include a compound having a structure containing oxygen (O), phosphorus (P), or sulfur (S) at each terminal of a central carbon atom connected to oxygen by a double bond.

The shielding material may include a compound having a structure containing oxygen (O), phosphorus (P), or sulfur (S) at one end of a central carbon atom connected to oxygen by a double bond and carbon (C) at the other end.

The shielding material may include one or more selected from compounds represented by Chemical Formulas 1 and 2 below.

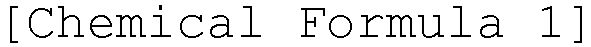

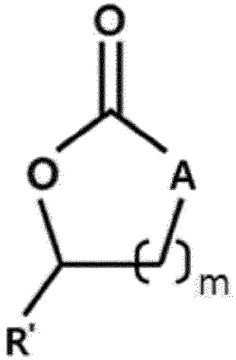

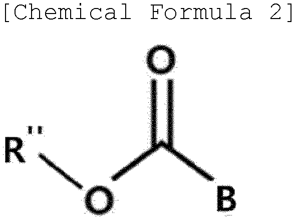

In Chemical Formulas 1 and 2, R' and R'' are independently hydrogen, an alkyl group having 1 to 5 carbon atoms, an alkene group having 1 to 5 carbon atoms, or an alkoxy group having 1 to 5 carbon atoms;
A is oxygen (O), sulfur (S), phosphorus (P), nitrogen (N), -CH, or -CH₂;
B is -OH, -OCH₃, -OCH₂CH₃, -CH₂CH₃, -SH, -SCH₃, or - SCH₂CH₃; and
m is an integer from 0 to 3.

The shielding material may include one or more selected from compounds represented by Chemical Formulas 1-1 to 1-4 and Chemical Formulas 2-1 to 2-4 below.

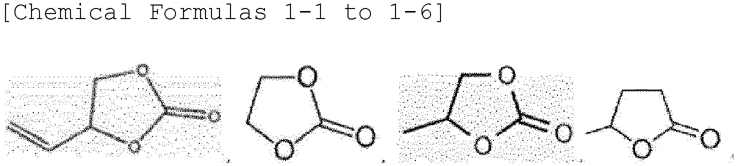

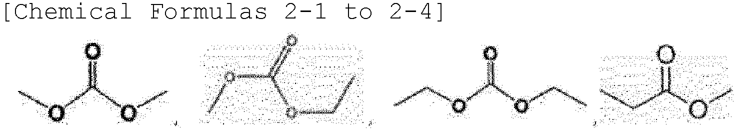

The shielding material may have a refractive index (measured at 20 to 25 °C) of 1.30 or more, 1.3 to 1.5, 1.35 to 1.48, or 1.36 to 1.46.

The diffusion-improving agent may have a boiling point of 5 to 200 °C, as a specific example, 10 to 150 °C, preferably 25 to 140 °C.

To improve diffusion and uniformity of the shielding material, the diffusion-improving agent may be preferably liquid at room temperature.

The diffusion-improving agent may include one or more selected from octane, diethyl ether, methylene chloride, toluene, hexane, and ethanol.

The diffusion-improving agent may have a refractive index of 1.30 or more, 1.30 to 1.70, 1.35 to 1.60, or 1.36 to 1.50.

The thin film modification composition may have a deposition rate reduction rate of 30 % or more as calculated by Equation 1 below. Deposition rate reduction rate = [{(DRi)-(DRf)}/(DRi)] × 100

In Equation 1, deposition rate (DR, Å/cycle) is the speed at which a thin film is deposited. In the deposition of a thin film formed from a precursor and a reactant, DRᵢ (initial deposition rate) is the deposition rate of the thin film formed without adding a diffusion-improving agent. DR_{f} (final deposition rate) is the deposition rate of the thin film formed by adding the diffusion-improving agent during the above process. Here, the deposition rate (DR) is a value measured at room temperature and pressure using an ellipsometer for a thin film with a thickness of 3 to 30 nm, and is expressed in a unit of Å/cycle.

The thin film may be a laminated film of one or more selected from the group consisting of Al, Si, Ti, V, Co, Ni, Cu, Zn, Ga, Ge, Se, Zr, Nb, Mo, Ru, Rh, In, Sn, Sb, Te, Hf, Ta, W, Re, Os, Ir, La, Ce, and Nd.

The thin film may be used as a diffusion barrier film, an etching stop film, an electrode film, a dielectric film, a gate insulating film, a block oxide film, or a charge trap.

In accordance with another aspect of the present invention, provided is a method of forming a thin film, the method including:
injecting a thin film modification composition including 50 to 99 parts by weight of a shielding material having one or more unshared electron pairs selected from oxygen (O), sulfur (S), and phosphorus (P) and 1 to 50 parts by weight of a diffusion-improving agent into a chamber to shield a surface of a loaded substrate, wherein the diffusion-improving agent comprises one or more selected from alkyl amines having a boiling point of 5 to 200 °C and aryl amines having a boiling point of 50 to 260 °C.

The precursor compound used in the method of forming a thin film may be a compound represented by Chemical Formula 3 below.

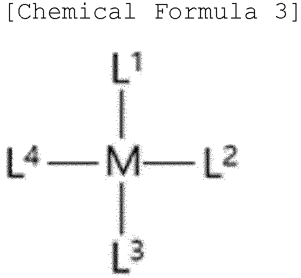

In Chemical Formula 3, M includes one or more selected from Al, Si, Ti, V, Co, Ni, Cu, Zn, Ga, Ge, Se, Zr, Nb, Mo, Ru, Rh, In, Sn, Sb, Te, Hf, Ta, W, Re, Os, Ir, La, Ce, and Nd; and L1, L2, L3, and L4 are -H, -X, -R, -OR, -NR, or Cp (cyclopentadiene) and are the same or different. Here, -X may be F, Cl, Br, or I; -R may be linear or circular C1-C10 alkyl, C1-C10 alkene, or C1-C10 alkane; and L1, L2, L3, and L4 may be formed from 2 to 6 depending on the oxidation number of a central metal.

For example, when the central metal is divalent, L1 and L2 may be attached to the central metal as ligands. When the central metal is hexavalent, L1, L2, L3, L4, L5, and L6 may be attached to the central metal. The ligands corresponding to L1 to L6 may be the same or different.

In Chemical Formula 3, L1, L2, L3, and L4 may be -H, -X, or -R, and may be the same or different. Here, -R may be linear or circular C1-C10 alkyl, C1-C10 alkene, or C1-C10 alkane.

In Chemical Formula 3, L1, L2, L3, and L4 may be -H, -OR, -NR, or Cp (cyclopentadiene), and may be the same or different. Here, -R may be H, C1-C10 alkyl, C1-C10 alkene, C1-C10 alkane, iPr, or TBu.

In Chemical Formula 3, L1, L2, L3, and L4 may be -H or -X, and may be the same or different. Here, -X may be F, Cl, Br, or I.

In accordance with still another aspect of the present invention, provided is a method of forming a thin film, the method including:
i) vaporizing the above-described thin film modification composition to shield a surface of a substrate loaded in a chamber;
ii) performing 1st purging inside the chamber with a purge gas;
iii) vaporizing a precursor compound and adsorbing the precursor compound onto an area outside the shielded area;
iv) performing 2nd purging inside the chamber with a purge gas;
v) supplying a reaction gas inside the chamber; and
vi) performing 3rd purging inside the chamber with a purge gas.

The precursor compound may be a molecule composed of one or more selected from the group consisting of Al, Si, Ti, V, Co, Ni, Cu, Zn, Ga, Ge, Se, Zr, Nb, Mo, Ru, Rh, In, Sn, Sb, Te, Hf, Ta, W, Re, Os, Ir, La, Ce, and Nd, and may be a precursor having a vapor pressure of greater than 0.01 mTorr and 100 Torr or less at 25 °C.

The chamber may be an ALD chamber, a CVD chamber, a PEALD chamber, or a PECVD chamber.

The thin film modification composition or the precursor compound may be vaporized, injected, and then subjected to plasma post-treatment.

In steps i) and iv), an amount of the purge gas injected into the chamber at each step may be 10 to 100,000 times the volume of the thin film modification composition injected.

The reaction gas may be an oxidizing agent, nitriding agent, or reducing agent, and the reaction gas, thin film modification composition, and precursor compound may be transferred into the chamber by a VFC, DLI, or LDS method.

The thin film may be a silicon nitride film, a silicon oxide film, a titanium nitride film, a titanium oxide film, a tungsten nitride film, a molybdenum nitride film, a hafnium oxide film, a zirconium oxide film, a tungsten oxide film, or an aluminum oxide film.

The substrate loaded into the chamber may be heated to 100 to 800 °C, and the ratio of amount (mg/cycle) of the thin film modification composition and the precursor compound fed into the chamber may be 1 : 1 to 1 : 20.

In accordance with still another aspect of the present invention, provided is a semiconductor substrate fabricated using the above-described method of forming a thin film.

The thin film may have a multilayer structure of two or more layers.

In accordance with yet another aspect of the present invention, provided is a semiconductor device including the above-described semiconductor substrate.

The semiconductor substrate may be low resistive metal gate interconnects, a high aspect ratio 3D metal-insulator-metal capacitor, a DRAM trench capacitor, 3D Gate-All-Around (GAA), or a 3D NAND flash memory.

### [Advantageous Effects]

According to the present invention, the present invention has an effect of providing a thin film modification composition that improves step coverage even when forming a thin film on a substrate with a complex structure under high-temperature conditions by effectively shielding adsorption on the surface of the substrate to improve reaction speed and reduce a thin film growth rate appropriately.

In addition, by effectively reducing process by-products during thin film formation, corrosion and deterioration can be prevented, and the film quality can be improved to improve the crystallinity of a thin film, thereby improving the electrical properties of the thin film.

In addition, the step coverage and density of a thin film can be improved. Furthermore, the present invention has an effect of providing a method of forming a thin film using the thin film modification composition and a semiconductor substrate including the thin film.

### [Description of Drawings]

FIG. 1 is a schematic diagram showing a deposition process sequence according to the present invention, focusing on one cycle.
FIG. 2 is a drawing comparing the calculated non-uniformity for each thin film obtained in Examples 1 and 2 and Comparative Examples 2 and 3 described below.
FIGS. 3 to 5 are TEM images measuring the step coverage at each of the upper and lower portions of each thin film obtained in Examples 1 to 3 described below.

### [Best Mode]

Hereinafter, a thin film modification composition of the present invention, a method of forming a thin film using the thin film modification composition, and a semiconductor substrate including the thin film will be described in detail.

In the present disclosure, unless otherwise specified, the term "shielding" means reducing, inhibiting, or blocking adsorption of precursor compounds for forming a thin film onto a substrate, and also reducing, inhibiting, or blocking adsorption of process by-products onto the substrate.

In the present disclosure, unless otherwise specified, the term "diffusion improvement" refers to improving uniformity by promoting diffusion of the shielding material.

The present inventors confirmed that, by using, in combination, a shielding material capable of shielding the adsorption of a precursor compound supplied to form a thin film on the surface of a substrate loaded inside a chamber and a diffusion-improving agent capable of improving the uniformity of the formed thin film, the reaction speed was improved under high-temperature conditions. In addition, even when applied to a substrate with a complex structure, film quality was improved, the uniformity of a thin film was ensured, step coverage was greatly improved. In particular, thin-thickness deposition was possible, and the remaining O, Si, metal, and metal oxides as process by-products and carbon residues, which were difficult to reduce in the past, were reduced. Based on these results, the present inventors conducted further studies on a thin film modification composition to complete the present invention.

For example, the thin film may be provided with one or more precursors selected from the group consisting of Al, Si, Ti, V, Co, Ni, Cu, Zn, Ga, Ge, Se, Zr, Nb, Mo, Ru, Rh, In, Sn, Sb, Te, Hf, Ta, W, Re, Os, Ir, La, Ce, and Nd, and may provide an oxide film, a nitride film, or a metal film. In this case, the effects desired in the present invention may be sufficiently achieved.

As a specific example, the thin film may have a film composition of a silicon nitride film, a silicon oxide film, a titanium nitride film, a titanium oxide film, a tungsten nitride film, a molybdenum nitride film, a hafnium oxide film, a zirconium oxide film, a tungsten oxide film, or an aluminum oxide film.

The thin film means the above-described film composition also including SiH and SiOH.

In addition to a commonly used diffusion barrier film, the thin film may be used in semiconductor devices as an etching stop film, an electrode film, a dielectric film, a gate insulating film, a block oxide film, or a charge trap.

In the present invention, the precursor compound used in the formation of the thin film may be a molecule having Al, Si, Ti, V, Co, Ni, Cu, Zn, Ga, Ge, Se, Zr, Nb, Mo, Ru, Rh, In, Sn, Sb, Te, Hf, Ta, W, Re, Os, Ir, La, Ce, or Nd as a central metal atom (M) and one or more ligands of C, N, O, H, and X (halogen). For a precursor having a vapor pressure of 1 mTorr to 100 Torr at 25 °C, the film quality improvement effect to be described later may be maximized.

For example, as the precursor compound, a compound represented by Chemical Formula 3 below may be used.

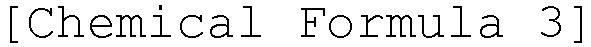

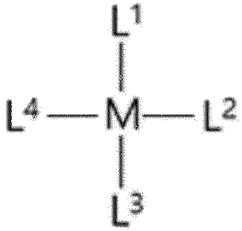

In Chemical Formula 3, M includes one or more selected from Al, Si, Ti, V, Co, Ni, Cu, Zn, Ga, Ge, Se, Zr, Nb, Mo, Ru, Rh, In, Sn, Sb, Te, Hf, Ta, W, Re, Os, Ir, La, Ce, and Nd; and L1, L2, L3, and L4 are -H, -X, -R, -OR, -NR, or Cp (cyclopentadiene), and are the same or different. Here, -X is F, Cl, Br, or I; and -R is linear or circular C1-C10 alkyl, C1-C10 alkene, or C1-C10 alkane.

In Chemical Formula 3, M is hafnium (Hf), silicon (Si), zirconium (Zr), or aluminum (Al), preferably hafnium (Hf) or silicon (Si). In this case, the effect of reducing process by-products and the effect of improving thin film density may be increased, and step coverage and the electrical properties, insulating properties, and dielectric properties of the thin film may be excellent.

L1, L2, L3, and L4 are -H, -X, or -R, and may be the same or different. Here, -R may be C1-C10 alkyl, C1-C10 alkene, or C1-C10 alkane and may have a linear or cyclic structure.

In addition, L1, L2, L3, and L4 are -H, -OR, -NR, or Cp (cyclopentadiene), and may be the same or different. Here, -R may be H, C1-C10 alkyl, C1-C10 alkene, C1-C10 alkane, iPr, or tBu.

In addition, in Chemical Formula 3, L1, L2, L3, and L4 may be -H or -X, and may be the same or different. Here, -X may be F, Cl, Br, or I.

Specifically, examples of the silicon precursor compound may include one or more selected from SiH₄, SiHCl₃, SiH₂Cl₂, SiCl₄, Si₂Cl₆ Si₃Cl₈, Si₄Cl₁₀, SiH₂[NH(C₄H₉)]₂, Si₂(NHC₂H₅)₄, Si₃NH₄(CH₃)₃, SiH₃[N(CH₃)₂], SiH₂[N(CH₃)₂]₂, SiH[N(CH₃)₂]₃, and Si[N(CH₃)₂]₄.

In addition, examples of the hafnium precursor compound may include tris(dimethylamido)cyclopentadienyl hafnium of CpHf(NMe₂)₃ and (methyl-3-cyclopentadienylpropylamino)bis(dimethylamino)hafnium of Cp(CH₂)₃NM₃Hf(NMe₂)₂.

In addition, examples of the aluminum precursor compound may include trimethyl aluminum (TMA), tris(dimethylamido)aluminum (TDMAA), and aluminum chloride (AlCl₃).

The thin film modification composition may be composed of a shielding material and a diffusion-improving agent.

Here, the shielding material may be a compound having at least one unshared electron pair selected from oxygen (O), sulfur (S), and phosphorus (P), preferably a compound having two or more oxygen (O), phosphorus (P), or sulfur (S) elements and including a linear or cyclic saturated or unsaturated hydrocarbon having 3 to 15 carbon atoms. In this case, by forming a shielded area that does not remain in a thin film during thin film formation, a relatively coarse thin film may be formed and side reactions may be suppressed. In addition, by controlling the thin film growth rate, process by-products within the thin film may be reduced, thereby reducing corrosion and deterioration. In addition, the crystallinity of the thin film may be improved, and a stoichiometric oxidation state may be reached when a metal oxide film is formed. In addition, even when a thin film is formed on a substrate with a complex structure under high-temperature conditions, step coverage and the thickness uniformity of a thin film may be greatly improved.

As a specific example, the shielding material includes a compound having a structure containing oxygen (O), phosphorus (P), or sulfur (S) at each terminal of a central carbon atom connected to oxygen by a double bond. Thus, the effect of reducing process by-products and the effect of improving thin film density may be increased, and step coverage and the electrical properties of the thin film may be excellent.

Here, unless otherwise specified, the structure containing oxygen (O), phosphorus (P), or sulfur (S) at each terminal of a central carbon atom connected to oxygen by a double bond refers to

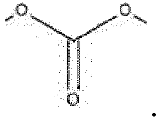

As a specific example, the shielding material has a structure containing oxygen (O), phosphorus (P), or sulfur (S) at one end of a central carbon atom connected by a double bond to oxygen and carbon (C) at the other end. Thus, the effect of reducing process by-products and the effect of improving thin film density may be increased, and step coverage and the electrical properties of the thin film may be excellent.

Here, unless otherwise specified, the structure containing oxygen (O), phosphorus (P), or sulfur (S) at one end of a central carbon atom connected by a double bond to oxygen and carbon (C) at the other end refers to

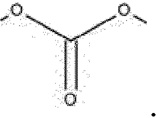

As a specific example, the shielding material may include one or more selected from compounds represented by Chemical Formulas 1 and 2 below. In this case, by forming a shielded area that does not remain in a thin film during thin film formation, a relatively coarse thin film may be formed and side reactions may be suppressed. In addition, by controlling the thin film growth rate, process by-products within the thin film may be reduced, thereby reducing corrosion and deterioration. In addition, the crystallinity of a thin film may be improved. In addition, even when a thin film is formed on a substrate having a complex structure, step coverage and the thickness uniformity of a thin film may be greatly improved.

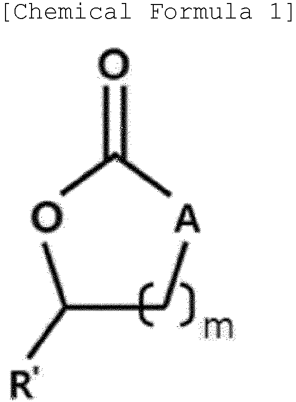

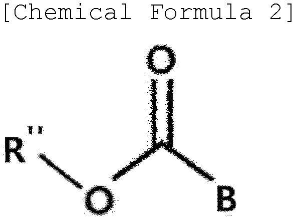

In Chemical Formulas 1 and 2, R' and R'' are independently hydrogen, an alkyl group having 1 to 5 carbon atoms, an alkene group having 1 to 5 carbon atoms, or an alkoxy group having 1 to 5 carbon atoms;
A is oxygen (O), sulfur (S), phosphorus (P), nitrogen (N), -CH, or -CH₂;
B is -OH, -OCH₃, -OCH₂CH₃, -CH₂CH₃, -SH, -SCH₃, or - SCH₂CH₃; and
m is an integer from 0 to 3.

In Chemical Formula 1, A is oxygen (O) or sulfur (S), preferably oxygen (O). In this case, the effect of reducing process by-products and the effect of improving thin film density may be increased, and step coverage and the electrical properties, insulating properties, and dielectric properties of the thin film may be excellent.

R' is an alkyl group having 1 to 3 carbon atoms, preferably an alkyl group having 1 to 2 carbon atoms. In this case, the effect of reducing process by-products and the effect of improving thin film density may be increased, and step coverage and the electrical properties, insulating properties, and dielectric properties of the thin film may be excellent.

m is an integer from 1 to 2, preferably an integer of 1.

In Chemical Formula 2, B is -OH, -OCH₃, -OCH₂CH₃, - CH₂CH₃, -SH, -SCH₃, or -SCH₂CH₃. In this case, the effect of reducing process by-products may be increased, step coverage may be excellent, and the effect of improving the density and electrical properties of a thin film may be excellent.

R'' is an alkyl group having 1 to 3 carbon atoms, preferably an alkyl group having 1 to 2 carbon atoms. In this case, the effect of reducing process by-products may be increased, step coverage may be excellent, and the effect of improving the density and electrical properties of a thin film may be excellent.

For example, when the shielding material is a compound represented by Chemical Formula 1, the shielding material may be a compound having a refractive index of 1.4 to 1.5, as a specific example, 1.4 to 1.48, preferably 1.4 to 1.

For example, when the shielding material is a compound represented by Chemical Formula 2, the shielding material may be a compound having a refractive index of 1.3 to 1.4, as a specific example, 1.33 to 1.39, preferably 1.35 to 1.39.

In this case, by forming, as a shielded area that does not remain in the thin film, a deposition layer of uniform thickness due to the difference in adsorption distribution of the shielding agent having the aforementioned structure on the substrate, the deposition rate of the thin film may be reduced, and the thin film growth rate may be appropriately reduced. Thus, even when a thin film is formed on a substrate having a complex structure under high-temperature conditions, step coverage and the thickness uniformity of a thin film may be greatly improved. In addition to a thin film precursor, the surface of the substrate may be effectively protected by preventing the adsorption of process by-products, and process by-products may be effectively removed.

In particular, as a relatively coarse thin film is formed, the growth rate of a thin film formed at the same time is greatly reduced, so that even when applied to a substrate having a complex structure, the uniformity of the thin film may be secured, and the step coverage may be greatly improved. In particular, deposition in a thin thickness is possible, and the remaining amounts of O, Si, metals, and metal oxides remaining as process by-products may be improved. In addition, even the remaining amount of carbon, which was difficult to reduce in the past, may be improved.

The shielding material may include one or more selected from compounds represented by Chemical Formulas 1-1 to 1-4 and Chemical Formulas 2-1 to 2-4 below. In this case, by providing a thin film-shielded area, the growth rate of a thin film may be effectively controlled, and process by-products may be effectively removed. In addition, step coverage and film quality may be improved. In addition, the uniformity of the formed thin film may be significantly improved.

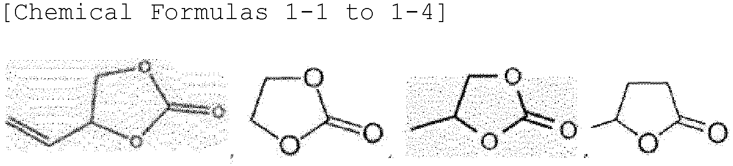

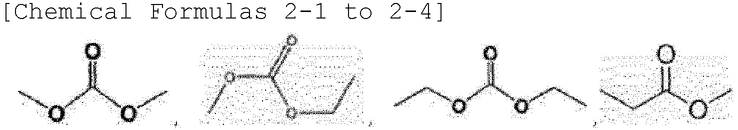

The diffusion-improving agent has a boiling point of 5 to 200 °C, 5 to 190 °C or 6 to 190 °C. In this case, the diffusion of the shielding material may be improved. In addition, by suppressing side reactions during thin film formation and controlling the thin film growth rate, process by-products within the thin film may be reduced, thereby reducing corrosion and deterioration. In addition, film quality including thin film crystallinity may be improved, and a stoichiometric oxidation state may be reached when a metal oxide film is formed. In addition, even when a thin film is formed on a substrate with a complex structure under high-temperature conditions, step coverage and the thickness uniformity of a thin film may be greatly improved.

For example, the diffusion-improving agent may have a solubility (25°C) of 200 mg/L or less, preferably 50 to 400 mg/L, more preferably 135 to 175 mg/L in water. Within this range, the reactivity toward the precursor compound may be reduced, and moisture may be easily managed.

In the present disclosure, solubility may be measured without any particular limitation by a measurement method or standard commonly used in the technical field to which the present invention pertains. For example, solubility may be measured by the HPLC method using a saturated solution.

The diffusion-improving agent, preferably one or more selected from octane, diethyl ether, and methylene chloride may have a deposition rate reduction rate of 30 % or more, as a specific example, 40 % or more, preferably 50 % or more as calculated by Equation 1 below. In this case, by forming a deposition layer with a uniform thickness due to the difference in adsorption distribution of the activator having the above-described structure as a shielded area that does not remain in the thin film, as a relatively coarse thin film is formed, the growth rate of a thin film formed at the same time is greatly reduced, so that even when applied to a substrate having a complex structure, the uniformity of the thin film may be secured, and the step coverage may be greatly improved. In particular, deposition in a thin thickness is possible, and the remaining amounts of O, Si, metals, and metal oxides remaining as process by-products may be improved. In addition, even the remaining amount of carbon, which was difficult to reduce in the past, may be improved. Deposition rate reduction rate = [{ (DRi)-(DRf)}/(DRi)] × 100

In Equation 1, deposition rate (DR, Å/cycle) is the speed at which a thin film is deposited. In the deposition of a thin film formed from a precursor and a reactant, DRᵢ (initial deposition rate) is the deposition rate of the thin film formed without adding a diffusion-improving agent. DR_{f} (final deposition rate) is the deposition rate of the thin film formed by adding the diffusion-improving agent during the above process. Here, the deposition rate (DR) is a value measured at room temperature and pressure using an ellipsometer for a thin film with a thickness of 3 to 30 nm, and is expressed in a unit of Å/cycle.

In Equation 1, when the thin film modification composition is used and when the thin film modification composition is not used, for each case, the thin film growth rate per cycle means the thin film deposition thickness (Å/cycle) per cycle, i.e., the deposition rate. For example, the deposition rate may be obtained as an average deposition rate calculated by measuring the final thickness of a thin film with a thickness of 3 to 30 nm under room temperature and pressure conditions using an ellipsometer, and then dividing the final thickness by the total number of cycles.

In Equation 1, "when the thin film modification composition is not used" means that a thin film is manufactured by adsorbing only a precursor compound on a substrate in a thin film deposition process. As a specific example, in the thin film forming method, the above case refers to a case where a thin film is formed by omitting a step of adsorbing a thin film modification composition and a step of purging an unadsorbed thin film modification composition.

For example, the diffusion-improving agent may be a compound having a refractive index of 1.30 or more, 1.30 to 1.70, 1.35 to 1.60, or 1.36 to 1.50.

In this case, by appropriately shielding the adsorption of the precursor compound on the substrate, the reaction speed may be improved. In addition, even when forming a thin film on a substrate with a complex structure, step coverage and the thickness uniformity of a thin film may be greatly improved. In addition to a thin film precursor, the surface of the substrate may be effectively protected by preventing the adsorption of process by-products, and process by-products may be effectively removed.

The thin film modification composition may include the shielding material and the diffusion-improving agent in a weight ratio of 50:50 to 99:1, as a specific example, 60:40 to 95:5, preferably 70:30 to 92:8, still more preferably 80:20 to 90:10. In this case, as a relatively coarse thin film is formed, the growth rate of a thin film formed at the same time is greatly reduced, so that even when applied to a substrate having a complex structure, the uniformity of the thin film may be secured, and the step coverage may be greatly improved. In particular, deposition in a thin thickness is possible, and the remaining amounts of O, Si, metals, and metal oxides remaining as process by-products may be improved. In addition, even the remaining amount of carbon, which was difficult to reduce in the past, may be improved.

For reference, the diffusion-improving agent may include octane having a boiling point of about 125.6°C, methylene chloride having a boiling point of 39.6°C, and diethyl ether having a boiling point of about 34.6°C.

The thin film modification composition may have a deposition rate reduction rate of 30 % or more as calculated by Equation 1 below. Deposition rate reduction rate = [{ (DRi)-(DRf)}/(DRi)] × 100

In Equation 1, deposition rate (DR, Å/cycle) is the speed at which a thin film is deposited. In the deposition of a thin film formed from a precursor and a reactant, DRᵢ (initial deposition rate) is the deposition rate of the thin film formed without adding a diffusion-improving agent. DR_{f} (final deposition rate) is the deposition rate of the thin film formed by adding the diffusion-improving agent during the above process. Here, the deposition rate (DR) is a value measured at room temperature and pressure using an ellipsometer for a thin film with a thickness of 3 to 30 nm, and is expressed in a unit of Å/cycle.

The shielded area for thin films does not remain on the thin film.

At this time, unless otherwise specified, non-residue refers to a case where the content of C element is less than 0.1 atom %, the content of Si element is less than 0.1 atom %, the content of N element is less than 0.1 atom %, and the content of halogen element is less than 0.1 atom % when analyzed by XPS. More preferably, in the secondary-ion mass spectrometry (SIMS) measurement method or X-ray photoelectron spectroscopy (XPS) measurement method, in which measurements are performed in the depth direction of a substrate, considering the increase/decrease rates of C, N, Si, and halogen impurities before and after using an activator under the same deposition conditions, it is desirable that the increase/decrease rate of the signal sensitivity (intensity) of each element type does not exceed 5 %.

For example, in the method of forming a thin film, when the thin film modification composition is used, the non-uniformity calculated by Equation 2 below may be less than 1.2 %, as a specific example, 1.1 % or less, preferably 0.01 to 1.1 %. In this case, by forming a deposition layer with a uniform thickness due to the difference in adsorption distribution of the step coverage improver having the above-described structure as a substitution area that does not remain in the thin film, as a relatively coarse thin film is formed, the growth rate of a thin film formed at the same time is greatly reduced, so that even when applied to a substrate having a complex structure, the uniformity of the thin film may be secured, and the step coverage may be greatly improved. In particular, deposition in a thin thickness is possible, and the remaining amounts of O, Si, metals, and metal oxides remaining as process by-products may be improved. In addition, even the remaining amount of carbon, which was difficult to reduce in the past, may be improved. Non-uniformity (%) = [{ (Maximum thickness - Minimum thickness)/2} × Average thickness] × 100

The maximum and minimum thicknesses were selected by measuring a thin film using an ellipsometer used for the above-described deposition rate reduction rate.

For example, it may be selected by measuring the thicknesses of 10 randomly selected locations, and preferably, it may be selected by measuring the thicknesses of 4 locations on the east, west, south, and north edges of a 300 mm wafer and 1 location in the center.

For example, the thin film may include a halogen compound in an amount of 100 ppm or less. For reference, when excess halogen remains, it is not desirable because by-products, such as NH₄Cl, may be generated and may remain in the thin film when using a nitriding agent under the experimental conditions of 200 to 300 °C described later.

The thin film may be used as an etching stop film, an electrode film, a dielectric film, a gate insulating film, a block oxide film, or a charge trap, without being limited thereto.

The thin film modification composition may be preferably a compound having a purity of 99.9 % or more, 99.95 % or more, or 99.99 % or more. For reference, when a compound having a purity of less than 99 % is used, impurities may remain in a thin film or cause side reactions with precursors or reactants. Accordingly, it is desirable to use a material having a purity of 99 % or more.

The thin film modification composition is preferably used in the atomic layer deposition (ALD) process. In this case, the surface of a substrate may be effectively protected and process by-products may be effectively removed without interfering with the adsorption of a precursor compound.

The thin film modification composition may preferably have a density of 0.8 to 2.5 g/cm³ or 0.8 to 1.5 g/cm³ and a vapor pressure (20 °C) of 0.1 to 300 mmHg or 1 to 300 mmHg. Within this range, step coverage, the thickness uniformity of a thin film, and film quality may be significantly improved.

More preferably, the thin film modification composition may have a density of 0.75 to 2.0 g/cm³ or 0.8 to 1.3 g/cm³ and a vapor pressure (20 °C) of 1 to 260 mmHg. Within this range, step coverage, the thickness uniformity of a thin film, and film quality may be significantly improved.

In particular, as a relatively coarse thin film is formed, the growth rate of a thin film formed at the same time is greatly reduced, so that even when applied to a substrate having a complex structure, the uniformity of the thin film may be secured, and the step coverage may be greatly improved. In particular, deposition in a thin thickness is possible, and the remaining amounts of O, Si, metals, and metal oxides remaining as process by-products may be improved. In addition, even the remaining amount of carbon, which was difficult to reduce in the past, may be improved.

The method of forming a thin film according to the present invention includes a step of injecting the above-described thin film modification composition into a chamber to replace the ligand of a precursor compound adsorbed on the surface of a loaded substrate. In this case, by effectively replacing the ligand of the precursor adsorbed on the substrate, the reaction speed may be improved and the thin film growth rate may be appropriately reduced. In addition, even when forming a thin film on a substrate with a complex structure, step coverage and the thickness uniformity of a thin film may be greatly improved.

In the step of shielding the thin film modification composition on the substrate, the feeding time (sec) of the thin film modification composition on the surface of the substrate may be preferably 0.01 to 10 seconds, more preferably 0.02 to 8 seconds, still more preferably 0.04 to 6 seconds, still more preferably 0.05 to 5 seconds per cycle. Within this range, thin film growth rate may be reduced, and step coverage and economics may be excellent.

In the present disclosure, the feeding time of the precursor compound is based on a flow rate of 0.1 to 500 mg/cycle at a chamber volume of 15 to 20 L, more specifically is based on a flow rate of 0.8 to 200 mg/cycle at a chamber volume of 18 L.

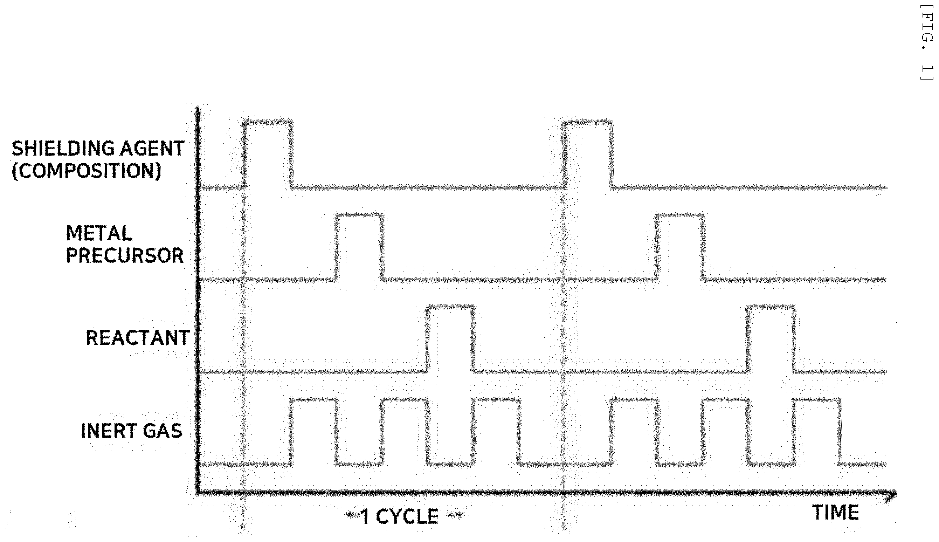

As a preferred example, the method of forming a thin film may include step i) of vaporizing the above-described thin film modification composition to shield the surface of a substrate loaded in a chamber; step ii) of performing 1st purging inside the chamber with a purge gas; step iii) of vaporizing a precursor compound and adsorbing the precursor compound onto an area outside the shielded area; step iv) of performing 2nd purging inside the chamber with a purge gas; step v) of supplying a reaction gas inside the chamber; and step vi) of performing 3rd purging inside the chamber with a purge gas. At this time, steps i) to vi) may be repeated as a unit cycle until a thin film of the desired thickness is obtained (see FIG. 1 below). In this way, in one cycle, when the thin film modification composition of the present invention is injected before the precursor compound to improve film quality, even when deposition is performed at high temperatures, the thin film growth rate may be appropriately reduced, process by-products may be effectively removed, the resistivity of the thin film may be reduced, and the step coverage may be significantly improved.

As a preferred example, in the method of forming a thin film according to the present invention, in one cycle, the thin film modification composition of the present invention may be introduced before the precursor compound and absorbed onto the substrate. In this case, even when depositing a thin film at high temperatures, process by-products may be significantly reduced and step coverage may be significantly improved by appropriately reducing the thin film growth rate. In addition, the crystallinity of the thin film may be increased, thereby reducing the resistivity of the thin film. In addition, even when applied to semiconductor devices with a large aspect ratio, the thickness uniformity of the thin film may be greatly improved, thereby ensuring the reliability of the semiconductor device.

For example, in the method of forming a thin film, when the thin film modification composition is deposited before or after the deposition of the precursor compound, depending on the needs, the unit cycle may be repeated 1 to 99,999 times, preferably 10 to 10,000 times, more preferably 50 to 5,000 times, still more preferably 100 to 2,000 times. Within this range, the desired thickness of the thin film may be obtained, and the effects intended for the present invention may be sufficiently achieved.

In the present invention, for example, the chamber may be an ALD chamber, a CVD chamber, a PEALD chamber, or a PECVD chamber.

In the present invention, the thin film modification composition or precursor compound may be vaporized, injected, and then subjected to plasma post-treatment. In this case, the growth rate of thin film may be improved and process by-products may be reduced.

When the precursor compound is adsorbed while injecting the thin film modification composition onto the substrate, the amount of purge gas injected into the chamber in the step of purging the unadsorbed thin film modification composition is not particularly limited as long as the amount is an amount sufficient to remove the unadsorbed thin film modification composition. For example, the amount of purge gas may be 10 to 100,000 times, preferably 50 to 50,000 times, more preferably 100 to 10,000 times. Within this range, the unadsorbed thin film modification composition may be sufficiently removed to form a thin film evenly and prevent deterioration of film quality. Here, the input amounts of the purge gas and the thin film modification composition are each based on one cycle, and the volume of the thin film modification composition means a volume of the vaporized thin film modification composition.

As a specific example, the thin film modification composition is injected (per cycle) at a flow rate of 1.66 mL/s for an injection time of 0.5 seconds. In the step of purging the unadsorbed thin film modification composition, when purge gas is injected (per cycle) at a flow rate 166.6 mL/s for an injection time 3 seconds, the injection amount of purge gas is 602 times the injection amount of thin film modification composition.

In the step of purging the unadsorbed precursor compound, the amount of purge gas injected into the chamber is not particularly limited as long as the amount is sufficient to remove the unadsorbed precursor compound. For example, the amount may be 10 to 10,000 times, preferably 50 to 50,000 times, more preferably 100 to 10,000 times the volume of the precursor compound injected into the chamber. Within this range, by sufficiently removing the unadsorbed precursor compound, a thin film may be formed evenly and deterioration of film quality may be prevented. Here, the input amounts of the purge gas and precursor compound are each based on one cycle, and the volume of the precursor compound refers to the volume of the vaporized precursor compound vapor.

In addition, in the purging step performed immediately after the reaction gas supply step, the amount of purge gas introduced into the chamber may be, for example, 10 to 10,000 times, preferably 50 to 50,000 times, more preferably 100 to 10,000 times the volume of reaction gas introduced into the chamber. Within this range, the desired effects may be sufficiently achieved. Here, the input amounts of purge gas and reaction gas are based on one cycle.

The thin film modification composition and the precursor compound may be transported into the chamber preferably by a VFC, DLI, or LDS method, more preferably an LDS method.

For example, the substrate loaded into the chamber may be heated to 50 to 400 °C, as a specific example, 50 to 400 °C. The thin film modification composition or the precursor compound may be injected onto the substrate in an unheated or heated state, or may be injected unheated and then heated during the deposition process, depending on the deposition efficiency. For example, the thin film modification composition or the precursor compound may be injected onto the substrate at 50 to 400 °C for 1 to 20 seconds.

The ratio of amount (mg/cycle) of the thin film modification composition and the precursor compound fed into the chamber may be preferably 1:1.5 to 1:20, more preferably 1:2 to 1:15, still more preferably 1:2 to 1:12, still more preferably 1:2.5 to 1:10. Within this range, step coverage may be improved, and process by-products may be greatly reduced.

The precursor material may be used in combination with a non-polar solvent.

The non-polar solvent may be an alkane or cycloalkane with 1 to 5 carbon atoms. Specifically, based on a total weight of the precursor compound and the non-polar solvent, the non-polar solvent may be included in an amount of 5 to 95 % by weight, more preferably 10 to 90 % by weight, still more preferably 40 to 90 % by weight, most preferably 70 to 90 % by weight.

Even when the above-described type of non-polar solvent is used, when the amount used exceeds the upper limit, impurities may be generated, which may increase the resistance and impurities within a thin film. When the content of the organic solvent is less than the range, the effect of improving step coverage due to solvent addition and the effect of reducing impurities such as chloride (Cl) ions may be reduced.

For example, in the method of forming a thin film, when the thin film modification composition is used, the deposition rate reduction rate calculated by Equation 1 below may be 30 % or more, as a specific example, 35 % or more. In this case, by forming a deposition layer of uniform thickness as a substitution area that does not remain in the thin film due to the difference in adsorption distribution of the activator having the aforementioned structure, as a relatively coarse thin film is formed, the growth rate of a thin film formed at the same time is greatly reduced, so that even when applied to a substrate having a complex structure, the uniformity of the thin film may be secured, and the step coverage may be greatly improved. In particular, deposition in a thin thickness is possible, and the remaining amounts of O, Si, metals, and metal oxides remaining as process by-products may be improved. In addition, even the remaining amount of carbon, which was difficult to reduce in the past, may be improved. Deposition rate reduction rate = [{(DRi)-(DRf)}/(DRi)] × 100

In Equation 1, deposition rate (DR, Å/cycle) is the speed at which a thin film is deposited. In the deposition of a thin film formed from a precursor and a reactant, DRᵢ (initial deposition rate) is the deposition rate of the thin film formed without adding a diffusion-improving agent. DR_{f} (final deposition rate) is the deposition rate of the thin film formed by adding the diffusion-improving agent during the above process. Here, the deposition rate (DR) is a value measured at room temperature and pressure using an ellipsometer for a thin film with a thickness of 3 to 30 nm, and is expressed in a unit of Å/cycle.

In the method of forming a thin film, the residual halogen intensity (c/s) in the thin film may be preferably 100,000 or less, more preferably 70,000 or less, still more preferably 50,000 or less, still more preferably 10,000 or less, as a preferred example, 5,000 or less, still more preferably 1,000 to 4,000, still more preferably 1,000 to 3,800 as measured using a thin film having a thickness of 100 Å according to SIMS. Within this range, corrosion and deterioration may be effectively prevented.

In the present disclosure, purging may be performed at preferably 1,000 to 50,000 sccm (standard cubic centimeter per minute), more preferably 2,000 to 30,000 sccm, still more preferably 2,500 to 15,000 sccm. Within this range, the thin film growth rate per cycle may be appropriately controlled. In addition, since deposition is performed as an atomic mono-layer or nearly an atomic mono-layer, the film quality may be improved.

The atomic layer deposition (ALD) process is very advantageous in manufacturing integrated circuits (ICs) that require a high aspect ratio. In particular, the ALD process has advantages such as excellent conformality, uniformity, and precise thickness control due to the self-limiting thin film growth mechanism.

For example, the method of forming a thin film may be performed at a deposition temperature of 50 to 800 °C, preferably 100 to 700 °C, more preferably 200 to 650 °C, still more preferably 220 to 400 °C. Within this range, a thin film with excellent film quality may be grown while implementing ALD process characteristics.

For example, the method of forming a thin film may be performed at a deposition pressure of 0.01 to 20 Torr, preferably 0.1 to 20 Torr, more preferably 0.1 to 10 Torr, most preferably 0.3 to 7 Torr. Within this range, a thin film having a uniform thickness may be obtained.

In the present disclosure, the deposition temperature and the deposition pressure may be measured as temperature and pressure formed within the deposition chamber, or as temperature and pressure applied to the substrate within the deposition chamber.

The method of forming a thin film may preferably include a step of increasing the temperature inside the chamber to the deposition temperature before introducing the thin film modification composition into the chamber; and/or a step of purging by injecting an inert gas into the chamber before introducing the thin film modification composition into the chamber.

In addition, as a thin film manufacturing device capable of implementing the thin film manufacturing method, the present invention may include a thin film manufacturing device including an ALD chamber, a first vaporizer for vaporizing the thin film modification composition, a first transport means for transferring the vaporized thin film modification composition into the ALD chamber, a second vaporizer for vaporizing the thin film precursor, and a second transport means for transferring the vaporized thin film precursor into the ALD chamber. Here, vaporizers and transport means commonly used in the technical field to which the present invention pertains may be used in the present invention without particular limitation.

When necessary, the first vaporizer of vaporizing a thin film modification composition may be composed of at least two types: a vaporizer for vaporizing a shielding material and a vaporizer for vaporizing a diffusion-improving agent.

As a specific example, the method of forming a thin film is explained. First, a substrate on which a thin film is to be formed is placed in a deposition chamber capable of atomic layer deposition.

The substrate may include a semiconductor substrate, such as a silicon substrate or a silicon oxide substrate.

The substrate may further have a conductive layer or an insulating layer formed on the upper portion thereof.

To deposit a thin film on the substrate positioned in the deposition chamber, the above-described thin film modification composition, a precursor compound, or a mixture of the precursor compound and a non-polar solvent is prepared.

Then, the prepared thin film modification composition (for example, shielding material) is injected into a vaporizer, is transformed into a vapor phase, is transferred into a deposition chamber, and is adsorbed on a substrate. Then, purging is performed to remove the unadsorbed thin film modification composition.

Next, the prepared precursor compound or mixture of the precursor compound and a non-polar solvent (composition for forming a thin film) is injected into the vaporizer, is transformed into a vapor phase, is transferred into the deposition chamber, and is adsorbed on the substrate. Then, shielding is performed by the preinjected shielding material, and the unadsorbed precursor compound or mixture of the precursor compound and a non-polar solvent is purged.

In the present disclosure, for example, the thin film modification composition and the precursor compound (composition for forming a thin film) may be delivered into the deposition chamber by vapor flow control (VFC) using mass flow control (MFC) or a liquid delivery system (LDS) using liquid mass flow control (LMFC), preferably an LDS method.

At this time, a mixed gas of one or more selected from the group consisting of argon (Ar), nitrogen (N₂), and helium (He) may be used as a carrier gas or dilution gas to move the thin film modification composition and the precursor compound onto the substrate, without being limited thereto.

In the present disclosure, for example, an inert gas, preferably the carrier gas or dilution gas may be used as the purge gas.

Next, a reaction gas is supplied. A reaction gas commonly used in the technical field to which the present invention pertains may be used in the present invention without particular limitation. Preferably, the reaction gas may contain a nitriding agent. The nitriding agent and the precursor compound adsorbed on the substrate react to form a nitride film.

Preferably, the nitriding agent may be nitrogen gas (N₂), hydrazine gas (N₂H₄), or a mixture of nitrogen gas and hydrogen gas.

Next, unreacted residual reaction gas is purged using an inert gas. Accordingly, in addition to excess reaction gas, generated byproducts may also be removed.

As described above, in the method of forming a thin film, for example, a step of supplying a shielding material onto a substrate, a step of purging the unadsorbed shielding material, a step of adsorbing a precursor compound/composition for forming a thin film on the substrate, a step of purging the unadsorbed precursor compound, a step of adsorbing a diffusion-improving agent onto the substrate, a step of purging the unadsorbed diffusion-improving agent, a step of supplying a reaction gas, and a step of purging the residual reaction gas may be set as a unit cycle. To form a thin film of desired thickness, the unit cycle may be repeated.

For example, the unit cycle may be repeated 1 to 99,999 times, preferably 10 to 1,000 times, more preferably 50 to 5,000 times, still more preferably 100 to 2,000 times. Within this range, the desired thin film properties may be well expressed.

In addition, the present invention provides a semiconductor substrate, and the semiconductor substrate is fabricated by the thin film formation method. In this case, the step coverage and thickness uniformity of a thin film may be excellent, and density and electrical properties may be excellent.

Preferably, the manufactured thin film may have a thickness of 20 nm or less, a resistivity value of 50 to 400 µΩ·cm based on a thin film thickness of 10 nm, a halogen content of 10,000 ppm or less, and a step coverage of 90 % or more. Within this range, the thin film has excellent performance as a diffusion barrier and has the effect of reducing corrosion of metal wiring materials, without being limited thereto.

For example, the thin film may have a thickness of 0.1 to 20 nm, preferably 1 to 20 nm, more preferably 3 to 25 nm, still more preferably 5 to 20 nm. Within this range, thin film properties may be excellent.

For example, based on a thin film thickness of 10 nm, the thin film may have a resistivity value of 0.1 to 400 µΩ·cm, preferably 15 to 300 µΩ·cm, more preferably 20 to 290 µΩ·cm, still more preferably 25 to 280 µΩ·cm. Within this range, thin film properties may be excellent.

The thin film may have a halogen content of preferably 10,000 ppm or less or 1 to 9,000 ppm, still more preferably 5 to 8,500 ppm, still more preferably 100 to 1,000 ppm. Within this range, thin film properties may be excellent, and thin film growth rate may be reduced. Here, the halogen remaining in the thin film may be, for example, Cl₂, Cl, or Cl⁻. As the halogen residue within the thin film decreases, the film quality increases.

For example, the thin film may have a step coverage of 90 % or more, preferably 92 % or more, more preferably 95 % or more. Within this range, since even a thin film of complex structure may be easily deposited on a substrate, the thin film may be applied to next-generation semiconductor devices.

Preferably, the manufactured thin film may have a thickness of 20 nm or less, a carbon, nitrogen, and halogen content of 10,000 ppm or less based on a thin film thickness of 10 nm, and a step coverage of 90 % or more. Within this range, the thin film may have excellent performance as a dielectric film or blocking film, without being limited thereto.

For example, when necessary, the thin film may have a multilayer structure of 2 or 3 layers. As a specific example, the multilayer film with a two-layer structure may have a lower layer-middle layer structure, and the multilayer film with a three-layer structure may have a lower layer-middle layer-upper layer structure.

For example, the lower layer may be formed of one or more selected from the group consisting of Si, SiO₂, MgO, Al₂O₃, CaO, ZrSiO₄, ZrO₂, HfSiO₄, Y₂O₃, HfO₂, LaLuO₂, Si₃N₄, SrO, La₂O₃, Ta₂O₅, BaO, and TiO₂.

For example, the middle layer may be formed of TiₓN_{y}, preferably TN.

For example, the upper layer may be formed of one or more selected from the group consisting of W and Mo.

Hereinafter, preferred examples and drawings are presented to help understand the present invention, but the following examples and drawings are only illustrative of the present invention, and it is obvious to those skilled in the art that various changes and modifications are possible within the scope and technical idea of the present invention. Such changes and modifications fall within the scope of the appended patent claims.

### [Examples]

### Examples 1 to 3, Comparative Examples 1 and 2

An ALD deposition process was performed according to FIG. 1 below using the components shown in Table 1 below.

FIG. 1 below is a schematic diagram showing a deposition process sequence according to the present invention, focusing on one cycle.

Specifically, as the shielding material, a compound represented by Chemical Formula 2-1 below was prepared. As the diffusion-improving agent, a compound represented by Chemical Formula 4-1 below, a compound represented by Chemical Formula 4-2 below, and a compound represented by Chemical Formula 4-3 below were prepared.

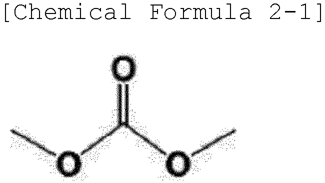

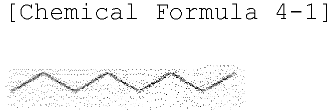

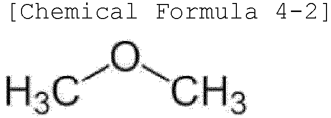

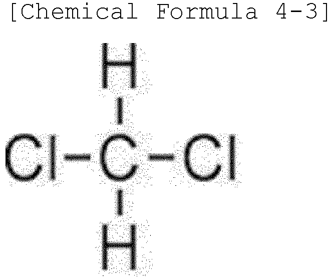

The thin film modification composition was prepared by mixing 90 parts by weight of the compound represented by Chemical Formula 2-1 and 10 parts by weight of the compound represented by Chemical Formula 4-1, and is designated as Composition 1 in Table 1.

The thin film modification composition was prepared by mixing 90 parts by weight of the compound represented by Chemical Formula 2-1 and 10 parts by weight of the compound represented by Chemical Formula 4-2, and is designated as Composition 2 in Table 2.

To prepare the thin film modification composition, 80 parts by weight of a compound represented by Chemical Formula 2-1 and 20 parts by weight of a compound represented by Chemical Formula 4-3 were mixed, and the mixture is indicated as Composition 3 in Table 1 below.

In addition, as the precursor, trimethylaluminum (indicated as TMA in the table below) was prepared.

As shown in FIG. 1 below, the prepared thin film modification composition, shielding material, or diffusion-improving agent was placed in a canister and supplied to a vaporizer heated to 150 °C at a flow rate of 0.05 g/min using a liquid mass flow controller (LMFC) at room temperature. The shielding material vaporized from the vaporizer was introduced into the deposition chamber loaded with the substrate for 1 second, and then argon gas was supplied at 5000 sccm for 2 seconds to perform argon purging. At this time, the pressure inside the reaction chamber was controlled to 2.5 Torr.

Next, the precursor was placed in a canister and introduced into the deposition chamber through a vapor flow controller (VFC) as shown in Table 1. Then, argon gas was supplied at 5000 sccm for 2 seconds to perform argon purging. At this time, the pressure inside the reaction chamber was controlled to 2.5 Torr.

Next, ozone as a reactive gas was injected into the reaction chamber at 1000 sccm for 3 seconds, followed by argon purging for 3 seconds. At this time, the substrate on which a metal thin film is to be formed was heated under the temperature conditions shown in Table 1 below.

By repeating this process 200 to 400 times, a self-limiting atomic layer thin film with a thickness of 10 nm was formed.

For each thin film obtained from Examples 1 to 3 and Comparative Examples 1 and 2, the deposition rate reduction rate (D/R reduction rate), SIMS C impurities, and step coverage were measured in the following manners.

* Deposition rate reduction rate (D/R (dep. rate) reduction rate): The deposition rate reduction rate represents the rate of reduction in the deposition rate after the thin film modification composition is added compared to the deposition rate before the thin film modification composition is added, and was calculated as a percentage using the measured A/cycle values.

Specifically, using an ellipsometer which is a device capable of measuring optical properties such as thickness and refractive index of the thin film by using the polarization characteristics of light for the manufactured thin film, the thickness of the thin film was measured. Then, the thickness of the thin film deposited per cycle was calculated by dividing the measured thickness by the number of cycles. Based on these results, the thin film growth rate reduction rate was calculated. Specifically, the calculation was performed using Equation 1 below. Deposition rate reduction rate = [{(DRi)-(DRf)}/(DRi)] × 100

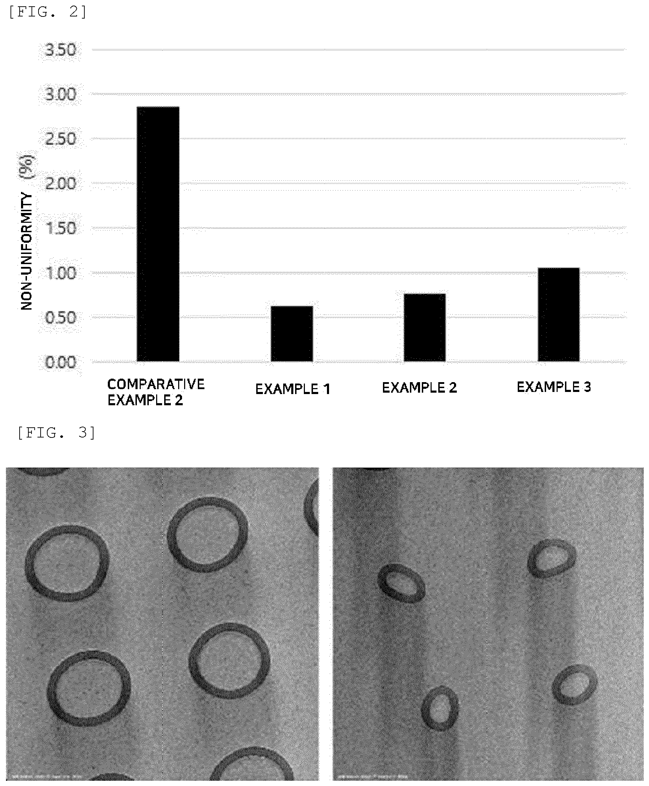

In Equation 1, deposition rate (DR, Å/cycle) is the speed at which a thin film is deposited. In the deposition of a thin film formed from a precursor and a reactant, DRᵢ (initial deposition rate) is the deposition rate of the thin film formed without adding a diffusion-improving agent. DR_{f} (final deposition rate) is the deposition rate of the thin film formed by adding the diffusion-improving agent during the above process. Here, the deposition rate (DR) is a value measured at room temperature and pressure using an ellipsometer for a thin film with a thickness of 3 to 30 nm, and is expressed in a unit of Å/cycle.
* To evaluate the non-uniformity, the maximum and minimum thicknesses were selected from the thicknesses of the thin film measured by the ellipsometer, and the results calculated using Equation 2 below are shown in Table 1 below and FIG. 2. Specifically, the thickness of four locations on the east, west, south, and north edges of a 300 mm wafer and the thickness of one location in the center were measured. Non-uniformity (%) = [{(Maximum thickness - Minimum thickness)/2} × Average thickness] × 100
* SIMS (Secondary-ion mass spectrometry) C impurities: The C impurity value was checked from the SIMS graph by considering the C impurity content (counts) when the thin film was axially penetrated by an ion sputter and the sputter time was 50 seconds with little contamination on the substrate surface layer.
* Step coverage (%): TEM measurements were taken on specimens cut horizontally at positions 100 nm downward from the upper portion (left drawing) and 100 nm upward from the lower portion (right drawing) of thin films deposited on a substrate of a complex structure with an aspect ratio of 22:1 by Examples 1 and 3 and Comparative Examples 1 and 2, and the step coverage was measured by Equation 3 below. Step coverage % = (Thickness deposited on inner wall of lower portion / Thickness deposited on inner wall of upper portion) × 100

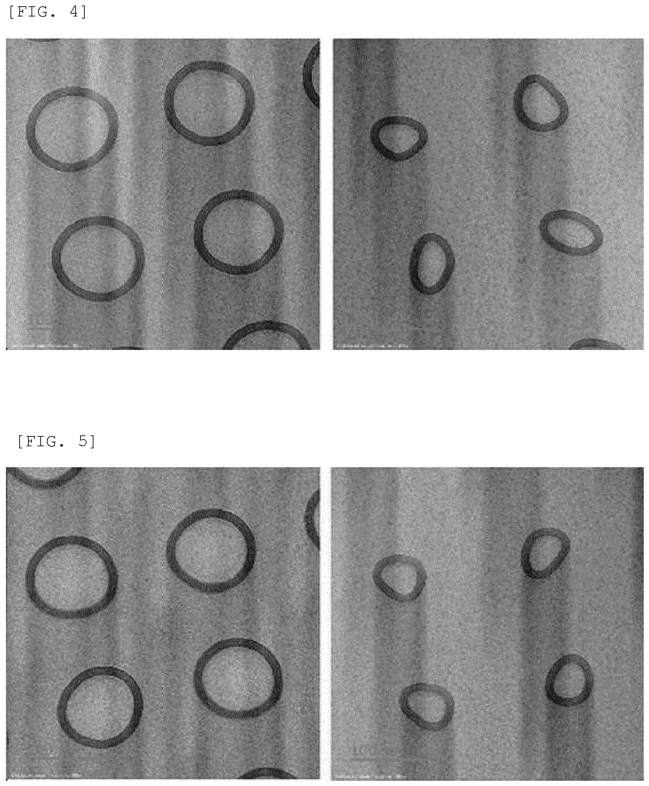

Specifically, on a substrate of a complex structure with an upper portion diameter of 90 nm, a lower portion diameter of 65 nm, a via hole depth of approximately 2000 nm, an aspect ratio of 22:1, a deposition process was performed using diffusion-improving agent application conditions. Then, to confirm the thickness uniformity and step coverage deposited inside the vertically formed via hole, a specimen was prepared by cutting horizontally at a position 100 nm downward from the upper portion and at a position 100 nm upward from the lower portion. Then, the specimen was observed using a transmission electron microscope (TEM), and the results are shown in Table 1 and FIGS. 3 to 5 below.

**[Table 1]**

| No. | Precursor | Reaction gas | Thin film modification composition | Deposition temperature | Precu rsor injection condi tion | Reaction gas injection condition | Thin film modification composition injecti on condition | Deposition rate (Å/cyc le) | Non-unifor mity (%) | Equation 1 calculation | Step coverage S/C (%) |
|---|---|---|---|---|---|---|---|---|---|---|---|
| Compar ative Exampl e 1 | TMA | O₃ | - | 400 °C | VFC, 3s, 100sc cm | 5s, 500sc cm | - | 0.75 | 1.20 | - | 95.0 |
| Compar ative Exampl e 2 | TMA | O₃ | Chemica l Formula 2-1 | 400 °C | VFC, 3s, 100sc cm | 5s, 500sc cm | 10mg/cy cle | 0.35 | 2.86 | 53 % | N/A |
| Exampl e 1 | TMA | O3 | Composi tion 1 | 420 °C | VFC, 3s, 100sc cm | 5s, 500sc cm | 10mg/cy cle | 0.35 | 0.63 | 53 % | 100. 2 |
| Exampl e 2 | TMA | O3 | Composi tion 2 | 400 °C | VFC, 3s, 100sc cm | 5s, 500sc cm | 10mg/cy cle | 0.36 | 0.77 | 52 % | 99.1 |
| Exampl e 3 | TMA | O3 | Composi tion 3 | 400 °C | VFC, 3s, 100sc cm | 5s, 500sc cm | 10mg/cy cle | 0.35 | 1.06 | 53 % | 99.5 |

As shown in Table 1, compared to Comparative Example 1 without using the thin film modification composition of the present invention, in Examples 1 to 3 using the thin film modification composition of the present invention, the deposition rate reduction rate and uniformity were significantly improved. In addition, Examples 1 to 3 using the thin film modification composition of the present invention exhibited deposition rate reduction rate equal or superior to that of Comparative Example 2 using a different type of the thin film modification composition of the present invention. In addition, Examples 1 to 3 exhibited excellent uniformity.

In particular, compared to Comparative Example 1 without using the thin film modification composition of the present invention or Comparative Example 2 using the shielding material alone, Examples 1 to 3 using the thin film modification composition of the present invention exhibited excellent uniformity (20 % or more) (see FIG. 2 below).

In addition, as shown in FIGS. 3 to 5 below, compared to the step coverage (95.0 %) of Comparative Example 1 without using the thin film modification composition of the present invention, Examples 1 to 3 using the thin film modification composition of the present invention exhibited significantly improved step coverage (99.1 to 100.2 %).

## Claims

1. A thin film modification composition, comprising 50 to 99 parts by weight of a shielding material having one or more unshared electron pairs selected from oxygen (O), sulfur (S), and phosphorus (P) and 1 to 50 parts by weight of a diffusion-improving agent,
wherein the diffusion-improving agent has a boiling point of 5 to 200 °C.

2. The thin film modification composition according to claim 1, wherein the shielding material comprises compounds represented by Chemical Formulas 1 and 2 below. 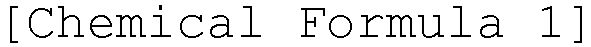 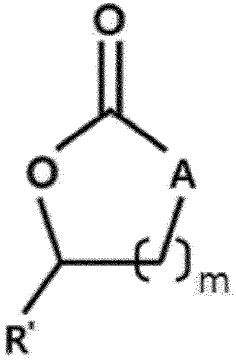 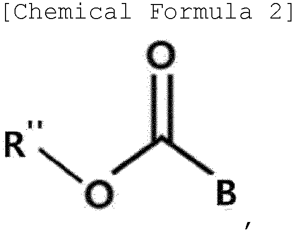
wherein, in Chemical Formulas 1 and 2, R' and R" are independently hydrogen, an alkyl group having 1 to 5 carbon atoms, an alkene group having 1 to 5 carbon atoms, or an alkoxy group having 1 to 5 carbon atoms;
A is oxygen (O), sulfur (S), phosphorus (P), nitrogen (N), -CH, or -CH₂;
B is -OH, -OCH₃, -OCH₂CH₃, -CH₂CH₃, -SH, -SCH₃, or - SCH₂CH₃; and
m is an integer from 0 to 3.

3. The thin film modification composition according to claim 1, wherein the shielding material comprises one or more selected from compounds represented by Chemical Formulas 1-1 to 1-4 and Chemical Formulas 2-1 to 2-4 below.

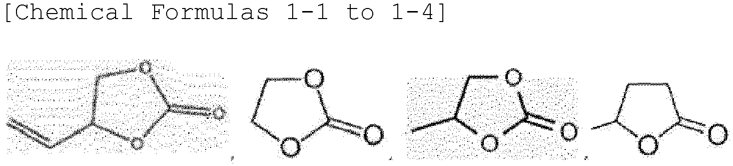

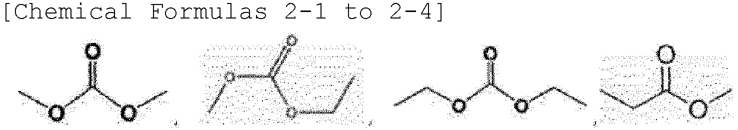

4. The thin film modification composition according to claim 1, wherein the diffusion-improving agent comprises one or more selected from octane, diethyl ether, methylene chloride, toluene, hexane, and ethanol.

5. The thin film modification composition according to claim 1, wherein the thin film controls a reaction surface of a thin film formed from one or more precursor compounds selected from the group consisting of Al, Si, Ti, V, Co, Ni, Cu, Zn, Ga, Ge, Se, Zr, Nb, Mo, Ru, Rh, In, Sn, Sb, Te, Hf, Ta, W, Re, Os, Ir, La, Ce, and Nd.

6. A method of forming a thin film, comprising injecting a thin film modification composition comprising 50 to 99 parts by weight of a shielding material having one or more unshared electron pairs selected from oxygen (O), sulfur (S), and phosphorus (P) and 1 to 50 parts by weight of a diffusion-improving agent into a chamber to shield a surface of a loaded substrate,
wherein the diffusion-improving agent has a boiling point of 5 to 200 °C.

7. The method according to claim 6, wherein the chamber is an ALD chamber, a CVD chamber, a PEALD chamber, or a PECVD chamber.

8. The method according to claim 6, wherein the thin film modification composition is transferred into the chamber by a VFC, DLI, or LDS method, and the thin film is a silicon nitride film, a silicon oxide film, a titanium nitride film, a titanium oxide film, a tungsten nitride film, a molybdenum nitride film, a hafnium oxide film, a zirconium oxide film, a tungsten oxide film, or an aluminum oxide film.

9. A semiconductor substrate, comprising the thin film manufactured using the method according to claim 6.

10. The semiconductor substrate according to claim 9, wherein the thin film has a multilayer structure of two or more layers.

11. A semiconductor device, comprising the semiconductor substrate according to claim 10.
